# EUROPÄISCHE PATENTSCHRIFT

(11) **EP 2 588 873 B1**
(45) Veröffentlichungstag und Bekanntmachung des Hinweises auf die Patenterteilung: **22.04.2015**
(21) Anmeldenummer: 11727472.0
(22) Anmeldetag: 27.06.2011
(51) Int. Cl.: G01R 31/02, G01R 31/00

(54) **VERFAHREN UND SCHALTUNGSANORDNUNG ZUR DIAGNOSE EINES LASTPFADES IN EINEM FAHRZEUG**
METHOD AND CIRCUIT ASSEMBLY FOR THE DIAGNOSIS OF A LOAD PATH IN A VEHICLE
PROCÉDÉ ET AGENCEMENT DE CIRCUIT POUR LE DIAGNOSTIC D'UN CHEMIN DE CHARGE DANS UN VÉHICULE

(30) Priorität: 01.07.2010 DE 102010030826
(43) Veröffentlichungstag der Anmeldung: 08.05.2013
(73) Patentinhaber: Robert Bosch GmbH, 70442 Stuttgart (DE)
(72) Erfinder: SZOKE, Szilard, H-1108 Budapest (HU); KOSZNAI, Zoltan, H-1221 Budapest (HU); FATER, Istvan, H-1171 Budapest (HU)
(86) Internationale Anmeldenummer: PCT/EP2011/060706
(87) Internationale Veröffentlichungsnummer: WO 2012/000931

(56) Entgegenhaltungen:
- EP-A1- 2 347 932
- EP-A2- 0 752 592
- WO-A2-2007/007111
- DE-A1- 4 112 996
- DE-A1- 4 338 462
- DE-A1- 4 432 301
- DE-A1- 19 644 181
- DE-A1-102004 049 906
- DE-A1-102006 045 308
- JP-A- 9 218 233

## Beschreibung

### Stand der Technik

Die Erfindung geht aus von einem Verfahren zur Diagnose eines Lastpfades in einem Fahrzeug nach der Gattung des unabhängigen Patentanspruchs 1, und von einer Schaltungsanordnung zur Diagnose eines Lastpfades nach der Gattung des unabhängigen Patentanspruchs 7.

Elektronische Steuergeräte sind zur Steuerung verschiedenster Funktionen und Einrichtungen allgemein bekannt und werden im Automotive-Bereich in zunehmendem Maße zur Steuerung verschiedenster Funktionen und/oder Applikationen eines Kraftfahrzeugs eingesetzt. Eine wichtige Klasse von solchen Funktionen und/oder Applikationen weisen so genannte "Low-Side-Lastschaltungen" auf, wobei ein erster Anschluss von solchen Lastschaltungen dauerhaft mit einem Minuspol einer Fahrzeugbatterie bzw. mit der Fahrzeugkarosserie verbunden ist und ein zweiter Anschluss der Lastschaltungen von einem elektronischen Steuergerät geschaltet wird. Die Lastschaltungen umfassen beispielsweise Elektromagnetventile, elektromechanische Relais, elektrische Motoren usw. Typischer Weise werden diese Lastschaltungen über einen Lastschalter geschaltet, welcher auch als "High-Side-Schalter" bezeichnet wird, dessen erster Anschluss dauerhaft mit einem Pluspol der Fahrzeugbatterie und dessen zweiter Anschluss mit dem zweiten Anschluss der Lastschaltung verbunden ist. Im Automotive-Bereich ist es üblich, vor der Aktivierung der Lastschaltung eine Diagnose durchzuführen. Die Diagnose ist insbesondere dann wichtig, wenn die Lastschaltung außerhalb des elektronischen Steuergeräts angeordnet und über elektrische Leitungen mit diesem verbunden ist. Durch die Diagnose sollen beispielsweise kurzgeschlossene oder gebrochene Leitungen, nicht angeschlossene Kabel usw. erkannt werden. Diese Fehlerfälle müssen von der normalen Schaltungssituation unterschieden werden. Eine Fehldiagnose bei einer kurzgeschlossenen Lastschaltung kann beispielsweise zu ausgelösten bzw. geschmolzenen Sicherungen, Fehlfunktionen im elektronischen Steuergerät oder zu thermischen Beschädigungen führen. In Abhängigkeit von der speziellen Funktion und/oder Applikation kann die Diagnose der Lastschaltung eine einfache oder komplexe Aufgabe sein. Bei einem häufig verwendeten Ansatz, wird ein hochohmigen Pull-up-Widerstand in die Leitung einschleift und die Spannung überwacht. In Abhängigkeit von der Spannung, welche vom elektronischen Steuergerät erfasst wird, kann der Zustand der Lastschaltung bestimmt werden. Übersteigt die erfasste Spannung bei einem offenen Lastschalter beispielsweise einen vorgegebenen Schwellwert, dann kann auf eine nicht angeschlossene Lastschaltung geschlossen werden. Niederohmig Lastschaltungen sind sehr schwer zu diagnostizieren, da der nominale Wert des Lastwiderstands fast einem ohmschen Widerstandswert bei einem typischen Kurzschluss entspricht. Der oben genannte Ansatz kann daher nicht zwischen einer kurzgeschlossenen Leitung und einem normalen Betriebszustand unterscheiden.

In der DE 41 12 996 A1 wird beispielsweise eine Schaltungsanordnung zur Diagnose eines Lastpfades in einem Fahrzeug beschrieben. Der Lastpfad umfasst eine Gleichspannungsquelle, eine mit einem Minuspol dauerhaft verbundene schaltbare Last und einen dauerhaft mit einem Pluspol verbundenen Lastschalter, welcher über ein Laststeuersignal steuerbar ist. Im geschlossenen Zustand des Lastschalters ist ein Laststrom durch die schaltbare Last leitbar. Des Weiteren sind mindestens eine Testspannungsquelle, welche eine Spannungsquelle und einen von einem Teststeuersignal gesteuerten Testschalter umfasst und so ausgeführt ist, dass während der Diagnose über mindestens einen Testwiderstand ein Teststrom mit einem definierten Pegel erzeugbar und an einem Ausgangsanschluss an die schaltbare ausgebbar ist, und eine Signalaufbereitungseinheit vorgesehen, welche während der Diagnose eine resultierende Spannung am Ausgangsanschluss erfasst und eine aufbereitete Testspannung zur Auswertung an eine Auswerte- und Steuereinheit ausgibt. Während der Diagnose ist der Lastschalter geöffnet. Über das Teststeuersignal und den resultierenden Schaltzustand des Testschalters sind mindestens zwei verschiedene Diagnosefälle erzeugbar.

In der DE 10 2006 045 308 A1 werden ein Verfahren und eine Schaltungsanordnung zum Detektieren des Zustands einer an einen Schaltanschluss verbindbaren Lasteinrichtung beschrieben. Hierbei ist der Schaltanschluss an ein vorgegebenes Schaltpotential koppelbar und entkoppelbar. Hierbei kann ein Verbundensein der Lasteinrichtung am Schaltanschluss, ein nicht Verbundensein der Lasteinrichtung am Schaltanschluss oder ein Kurzschluss zwischen dem Schaltanschluss und einem ersten oder einem zweiten Schaltungspotential in Abhängigkeit von einem Spannungsabfall am Schaltanschluss erkannt werden, wobei zeitgleich mit einem Entkoppeln des Schaltanschlusses von dem vorgegebenen Schaltpotential eine Zusatzstromquelle an den Schaltanschluss verbunden wird.

In der DE 44 32 301 A1 wird ein elektronisches Steuergerät für Rückhaltesysteme beschrieben, welches verschiedene Messvorgänge zur Überprüfung der Funktionsfähigkeit des Steuergeräts und eines korrespondierenden Zündkreises durchführen kann. Der Zündkreis umfasst eine Gleichspannungsquelle, eine mit einem Minuspol dauerhaft verbundene schaltbare Last und einen dauerhaft mit einem Pluspol verbundenen Lastschalter, welcher über ein Laststeuersignal steuerbar ist. Im geschlossenen Zustand des Lastschalters ist ein Laststrom durch die schaltbare Last leitbar, wobei während der Diagnose ein schaltbarer Teststrom mit einem definierten Pegel erzeugt und in Abhängigkeit von einem Teststeuersignal über einen Testschalter an einem Ausgangsanschluss an die schaltbare Last ausgegeben wird. Hierbei wird eine resultierende Spannung am Ausgangsanschluss erfasst, aufbereitet und ausgewertet, wobei der Lastschalter während der Diagnose geöffnet wird. Über das Teststeuersignal und den resultierenden Schaltzustand des Testschalters werden mindestens zwei verschiedene Diagnosefälle erzeugt, wobei die mindestens zwei verschiedenen Diagnosefälle statische und dynamische Diagnosefälle umfassen. Zur Erkennung und Unterscheidung von verschiedenen Lastpfadzuständen werden die statischen und dynamischen Diagnosefälle, kombiniert. So wird in einem ersten statischen Diagnosefall die resultierende Spannung am Ausgangsanschluss bei geöffnetem Testschalter erfasst und die korrespondierende aufbereitete Testspannung wird ausgewertet. In einem zweiten statischen Diagnosefall wird die resultierende Spannung am Ausgangsanschluss bei geschlossenem Testschalter erfasst und die korrespondierende aufbereitete Testspannung wird ausgewertet. Hierbei wird die aufbereitete Testspannung jeweils erst nach Ablauf einer vorgegebenen Zeitspanne im eingeschwungenen Zustand ausgewertet. Dadurch können beispielsweise Kurzschlüsse zwischen Anschlüssen der Versorgungsspannung und Anschlussleitungen der Last, ein ohmscher Widerstand der Endstufe, welcher sich aus dem Widerstand des Zündelements, den Widerständen der Anschlussleitungen und den Steckverbindungen zusammensetzt, und die Kapazität des Zündelements ermittelt und zur Korrektur des gemessenen Widerstands ausgewertet werden.

### Offenbarung der Erfindung

Das erfindungsgemäße Verfahren zur Diagnose eines Lastpfades in einem Fahrzeug mit den Merkmalen des unabhängigen Patentanspruchs 1 hat demgegenüber den Vorteil, dass während der Diagnose ein schaltbarer Teststrom mit einem definierten Pegel erzeugt und in Abhängigkeit von einem Teststeuersignal über einen Testschalter an einem Ausgangsanschluss an die schaltbare Last ausgegeben wird, wobei eine resultierende Spannung am Ausgangsanschluss erfasst, aufbereitet und ausgewertet wird, wobei der Lastschalter während der Diagnose geöffnet ist, und wobei über das Teststeuersignal und den resultierenden Schaltzustand des Testschalters mindestens zwei verschiedene Diagnosefälle erzeugt werden. Der Lastpfad umfasst eine Gleichspannungsquelle, eine mit einem Minuspol dauerhaft verbundene schaltbare Last und einen dauerhaft mit einem Pluspol verbundenen Lastschalter, welcher über ein Laststeuersignal steuerbar ist, wobei im geschlossenen Zustand des Lastschalters ein Laststrom durch die schaltbare Last geleitet wird. Das erfindungsgemäße Verfahren kann insbesondere in einem elektrischen Steuergerät mit einem Mikroprozessor einfach und schnell implementiert werden.

In einem ersten statischen Diagnosefall wird die resultierende Spannung am Ausgangsanschluss bei geöffnetem Testschalter erfasst und die korrespondierende aufbereitete Testspannung wird ausgewertet, und in einem zweiten statischen Diagnosefall wird die resultierende Spannung am Ausgangsanschluss bei geschlossenem Testschalter erfasst und die korrespondierende aufbereitete Testspannung wird ausgewertet, wobei die aufbereitete Testspannung jeweils erst nach Ablauf einer vorgegebenen Zeitspanne im eingeschwungenen Zustand ausgewertet wird. Erfindungsgemäß ist eine nominale induktive schaltbare Last erkennbar aber nicht unterscheidbar, wenn die korrespondierende aufbereitete Testspannung im ersten statischen Diagnosefall und im zweiten statischen Diagnosefall einen niedrigen Pegel aufweist.

Die erfindungsgemäße Schaltungsanordnung zur Diagnose eines Lastpfades in einem Fahrzeug, insbesondere zur Durchführung des erfindungsgemäßen Verfahrens, umfasst mindestens eine Testspannungsquelle, welche eine Spannungsquelle und einen von einem Teststeuersignal gesteuerten Testschalter umfasst und so ausgeführt ist, dass während der Diagnose über mindestens einen Testwiderstand ein Teststrom mit einem definierten Pegel erzeugbar und an einem Ausgangsanschluss an die schaltbare Last ausgebbar ist, und eine Signalaufbereitungseinheit, welche während der Diagnose eine resultierende Spannung am Ausgangsanschluss erfasst und eine aufbereitete Testspannung zur Auswertung an eine Auswerte- und Steuereinheit ausgibt, wobei der Lastschalter während der Diagnose geöffnet ist, und wobei über das Teststeuersignal und den resultierenden Schaltzustand des Testschalters mindestens zwei verschiedene Diagnosefälle erzeugbar sind.

Erfindungsgemäß weist die Signalaufbereitungseinheit zur Durchführung einer kombinierten statischen und dynamischen Diagnose einen Spannungsteiler auf, wobei parallel zu einem mit dem Ausgangsanschluss verbundenen ersten Widerstand des Spannungsteilers ein Koppelkondensator angeordnet ist, und wobei im Signalweg nach dem Spannungsteiler ein Tiefpassfilter angeordnet ist.

Durch Ausführungsformen der vorliegenden Erfindung können während der Diagnose des Lastpfads in vorteilhafter Weise eine nominale Last, d.h. eine fehlerfreie Last, ein Kurzschluss zwischen dem Ausgangsanschluss und dem Pluspol der Gleichspannungsquelle, ein Kurzschluss zwischen dem Ausgangsanschluss und dem Minuspol der Gleichspannungsquelle bzw. eine offene Last bzw. ein gebrochenes Anschlusskabel voneinander unterschieden und als Diagnoseergebnisse erkannt werden.

Durch den schaltbaren Teststrom können die oben genannten Diagnoseergebnisse in vorteilhafter Weise für Lastschaltungen unterschieden werden, welche im Wesentlichen ein ohmsches Verhalten aufweisen. Die verschiedenen Diagnosefälle umfassen in vorteilhafter Weise statische und dynamische Diagnosefälle, wobei über die statischen Diagnosefälle eine gebrochene Leitung, d.h. eine nicht angeschlossene Last, oder ein Kurzschluss zwischen dem Ausgangsanschluss und dem Pluspol einer Gleichspannungsquelle auch bei einer induktiven Last mit niedrigem ohmschen Widerstand unterschieden und sicher erkannt werden können. Die Unterscheidung zwischen einem Kurzschluss zwischen dem Ausgangsanschluss und dem Minuspol der Gleichspannungsquelle und einer nominalen Last ist bei einer solchen induktiven Last mit niedrigem ohmschen Widerstand jedoch über die statischen Diagnosefälle nicht möglich. Eine solche Unterscheidung ermöglichen in vorteilhafter Weise die dynamischen Diagnosefälle, da über die Ermittlung eines Frequenzverhaltens bzw. einer Sprungantwort der induktiven Last mit niedrigem ohmschen Widerstand ein normales Verhalten der Last und ein Kurzschluss zwischen dem Ausgangsanschluss und dem Minuspol bzw. der Fahrzeugkarosserie sicher erkannt und unterschieden werden können.

Durch die in den abhängigen Ansprüchen aufgeführten Maßnahmen und Weiterbildungen sind vorteilhafte Verbesserungen des im unabhängigen Patentanspruch 1 angegebenen Verfahrens zur Diagnose eines Lastpfades in einem Fahrzeug, und der im unabhängigen Patentanspruch 7 angegebenen Schaltungsanordnung zur Diagnose eines Lastpfades möglich.

In vorteilhafter Ausgestaltung des erfindungsgemäßen Verfahrens wird in einem ersten dynamischen Diagnosefall der Testschalters durch das Teststeuersignal mit einer vorgegebenen Frequenz zwischen einem geschlossenen und einem geöffneten Schaltzustand umgeschaltet und die resultierende Spannung am Ausgangsanschluss erfasst und die korrespondierende aufbereitete Testspannung zur Ermittlung des Frequenzverhaltens der schaltbaren Last am Ausgangsanschluss ausgewertet. Alternativ kann in einem zweiten dynamischen Diagnosefall der Testschalter innerhalb einer vorgegebenen Zeitspanne mindestens einmal geschlossen und geöffnet werden, wobei die resultierende Spannung am Ausgangsanschluss erfasst und die korrespondierende aufbereitete Testspannung innerhalb der vorgegebenen Zeitspanne zur Ermittlung des Sprungantwortverhaltens der schaltbaren Last am Ausgangsanschluss ausgewertet werden.

In weiterer vorteilhafter Ausgestaltung des erfindungsgemäßen Verfahrens kann ein Kurzschluss zwischen dem Pluspol der Gleichspannungsquelle und dem Ausgangsanschluss der schaltbaren Last erkannt werden, wenn die korrespondierende aufbereitete Testspannung im ersten statischen Diagnosefall und im zweiten statischen Diagnosefall einen hohen Pegel aufweist. Des Weiteren kann eine offene schaltbare Last erkannt werden, wenn die korrespondierende aufbereitete Testspannung im ersten statischen Diagnosefall und im zweiten statischen Diagnosefall unterschiedliche Pegel aufweist. Zudem kann ein Kurzschluss zwischen dem Minuspol der Gleichspannungsquelle und dem Ausgangsanschluss der schaltbaren Last erkannt aber nicht unterschieden werden, wenn die korrespondierende aufbereitete Testspannung im ersten statischen Diagnosefall und im zweiten statischen Diagnosefall einen niedrigen Pegel aufweist. Eine nominale induktive schaltbare Last kann erkannt werden, wenn die korrespondierende aufbereitete Testspannung im ersten dynamischen Diagnosefall einen hohen Pegel aufweist oder wenn die korrespondierende aufbereitete Testspannung im zweiten dynamischen Diagnosefall nach dem Schließen des Testschalters innerhalb der vorgegebenen Zeitspanne einen positiven Impuls aufweist. Ein Kurzschluss zwischen dem Minuspol der Gleichspannungsquelle und dem Ausgangsanschluss der schaltbaren Last kann erkannt werden, wenn die korrespondierende aufbereitete Testspannung im ersten dynamischen Diagnosefall einen niedrigen Pegel aufweist oder wenn die korrespondierende aufbereitete Testspannung im zweiten dynamischen Diagnosefall während der vorgegebenen Zeitspanne unabhängig vom Schaltzustand des Testschalters einen niedrigen Pegel aufweist.

Des Weiteren führt die Auswerte- und Steuereinheit zuerst die statische Diagnose und dann die dynamische Diagnose des mindestens einen Lastpfades durch.

In weiterer vorteilhafter Ausgestaltung der erfindungsgemäßen Schaltungsanordnung sind der mindestens eine Testwiderstand und die Widerstände in der Signalaufbereitungseinheit so aufeinander abgestimmt, dass der Teststrom einen vorgegebenen Schwellwert nicht übersteigt, um eine Aktivierung der schaltbaren Last zu verhindern. Dadurch kann in vorteilhafter Weise verhindert werden, dass ein elektrisches Relais anzieht und ein zugehöriger Schaltkontakt geschlossen wird.

Ausführungsbeispiele der Erfindung sind in den Zeichnungen dargestellt und werden in der nachfolgenden Beschreibung näher erläutert.

### Kurze Beschreibung der Zeichnungen

Fig. 1 zeigt ein schematisches Blockdiagramm eines Ausführungsbeispiels einer erfindungsgemäßen Schaltungsanordnung zur Diagnose eines Lastpfades.
Fig. 2 zeigt ein schematisches Blockdiagramm eines ersten Beispiels einer Signalaufbereitungseinheit für die Schaltungsanordnung aus Fig. 1.
Fig. 3 zeigt ein schematisches Blockdiagramm eines zweiten Beispiels einer Signalaufbereitungseinheit für die Schaltungsanordnung aus Fig. 1.
Fig. 4 zeigt ein schematisches Blockdiagramm eines Ausführungsbeispiels einer Signalaufbereitungseinheit für die erfindungsgemäße Schaltungsanordnung aus Fig. 1.
Fig. 5 zeigt ein schematisches Blockdiagramm eines Ausführungsbeispiels einer erfindungsgemäßen Schaltungsanordnung zur Diagnose von mehreren Lastpfaden.
Fig. 6 zeigt ein Kennliniendiagramm mit mehreren Signalen, welche in einem ersten dynamischen Diagnosefall in der Schaltung gemäß Fig. 3 gemessen werden, wobei die dargestellten Signale als Diagnoseergebnis eine nominale induktive Last repräsentieren.
Fig. 7 zeigt ein Kennliniendiagramm mit mehreren Signalen, welche in einem weiteren ersten dynamischen Diagnosefall in der Schaltung gemäß Fig. 3 gemessen werden, wobei die dargestellten Signale als Diagnoseergebnis einen Kurzschluss zwischen dem Ausgangsanschluss und dem Minuspol der Gleichspannungsquelle repräsentieren.
Fig. 8 zeigt ein Kennliniendiagramm mit mehreren Signalen, welche in einem zweiten dynamischen Diagnosefall in der Schaltung gemäß Fig. 4 gemessen werden, wobei die dargestellten Signale als Diagnoseergebnis eine nominale induktive Last repräsentieren.
Fig. 9 zeigt ein Kennliniendiagramm mit mehreren Signalen, welche in einem weiteren zweiten dynamischen Diagnosefall in der Schaltung gemäß Fig. 3 gemessen werden, wobei die dargestellten Signale als Diagnoseergebnis einen Kurzschluss zwischen dem Ausgangsanschluss und dem Minuspol der Gleichspannungsquelle repräsentieren.

### Ausführungsformen der Erfindung

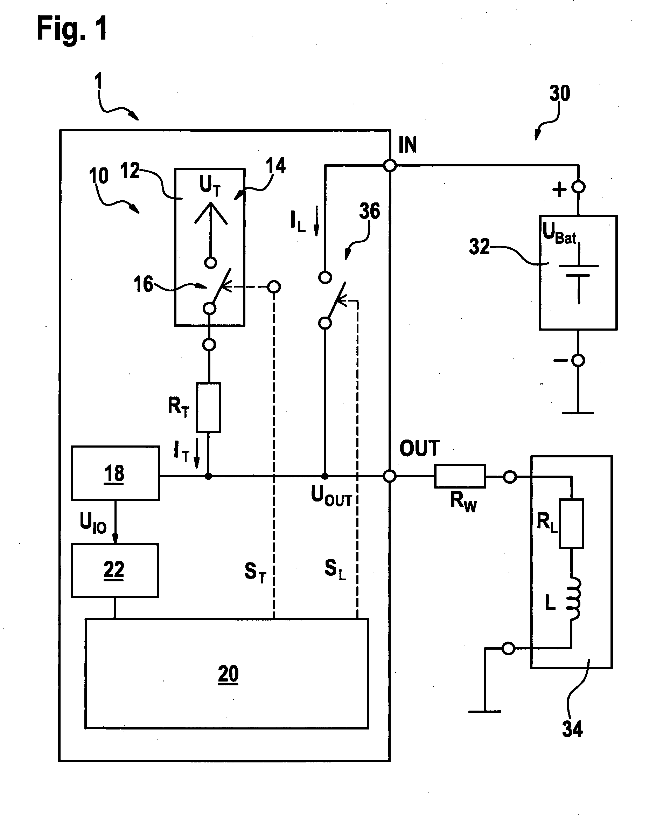

Wie aus Fig. 1 ersichtlich ist, umfasst ein Lastpfad 30 in einem Fahrzeug eine Gleichspannungsquelle 32, eine mit einem Minuspol (-) der Gleichspannungsquelle 32 dauerhaft verbundene schaltbare Last 34 und einen dauerhaft mit einem Pluspol (+) der Gleichspannungsquelle 32 verbundenen Lastschalter 36, welcher innerhalb eines elektronischen Steuergeräts 1 zwischen einem Eingangsanschluss IN und einem Ausgangsanschluss OUT angeordnet ist und über ein Laststeuersignal S_{L} steuerbar ist, welches von einer Auswerte- und Steuereinheit 20 des elektronischen Steuergeräts 1 erzeugt und ausgegeben wird. Im geschlossenen Zustand des Lastschalters 36 ist ein Laststrom I_{L} durch die schaltbare Last 34 leitbar. Im dargestellten Ausführungsbeispiel ist die schaltbare Last 34 als Ersatzschaltung einer induktiven Last, wie beispielsweise eine elektrische Relaisspule, ein Elektromagnetventil, ein elektrischer Motor usw., mit einer idealen Induktivität L, welche größer als 100µH ist, und einem niedrigen ohmschen Widerstand R_{L} dargestellt, welcher kleiner als 10Ω ist. Im Widerstand R_{w}, welcher ebenfalls kleiner als 10Ω ist und zwischen der schaltbaren Last 34 und dem Ausgangsanschluss OUT eingeschleift ist, sind die ohmschen Verluste der Leitungen, Anschlüsse usw. berücksichtigt.

Erfindungsgemäß umfasst eine Schaltungsanordnung 10 zur Diagnose des Lastpfads 30 mindestens eine Testspannungsquelle 12, welche eine Spannungsquelle 14 und einen von einem Teststeuersignal S_{T} gesteuerten Testschalter 16 aufweist und so ausgeführt ist, dass aus einer Testspannung U_{T} der Spannungsquelle 14 während der Diagnose über mindestens einen Testwiderstand R_{T} ein Teststrom I_{T} mit einem definierten Pegel erzeugbar und am Ausgangsanschluss OUT an die schaltbare Last 34 ausgebbar ist, und eine Signalaufbereitungseinheit 18, welche während der Diagnose eine resultierende Spannung U_{OUT} am Ausgangsanschluss OUT erfasst und eine aufbereitete Testspannung U_{IO} zur Auswertung an die Auswerte- und Steuereinheit 20 ausgibt. Während der Diagnose ist der Lastschalter 36 geöffnet, so dass kein Laststrom I_{L} durch die schaltbare Last 34 fließt. Über das Teststeuersignal S_{T} und den resultierenden Schaltzustand des Testschalters 16 können in vorteilhafter Weise mindestens zwei verschiedene Diagnosefälle erzeugt werden. Zwischen der Signalaufbereitungseinheit 18 und der Auswerte- und Steuereinheit 20 ist eine Schnittstelleneinheit 22 angeordnet, welche einen einfachen logischen Eingang eines Mikroprozessors oder einen Analog-Digital-Wandler umfassen kann. Der Testschalter 16 kann beispielsweise als Bipolartransistor, Feldeffekttransistor, Relais usw. ausgeführt sein. Die Spannungsquelle 14 ist vorzugsweise als Gleichspannungsquelle ausgeführt, wobei durch eine entsprechende Ansteuerung des Testschalters 16 über das Teststeuersignal S_{T} eine im Wesentlichen rechteckförmige Wechselspannung auf einfache Art und Weise erzeugt werden kann. Durch den differenziellen Charakter der R-L-Schaltung aus der idealen Induktivität L und den Widerständen R_{L}, R_{W} stellen sich am Ausgangsanschluss OUT für einen jeweiligen Rechteckimpuls ein entsprechender positiver Spannungsimpuls an der ansteigenden Flanke des Rechteckimpulses und ein entsprechender negativer Spannungsimpuls an der abfallenden Flanke des Rechteckimpulses ein. Für die dynamische Diagnose können ein oder mehrere Rechteckimpulse verwendet werden, wie nachfolgend ausgeführt wird. Zudem können während der Diagnose für jeden Lastpfad mehrere Messungen durchgeführt und die Ergebnisse gemittelt und/oder bewertet werden, um die Zuverlässigkeit der erfindungsgemäßen Schaltungsanordnung und des erfindungsgemäßen Verfahrens zu verbessern.

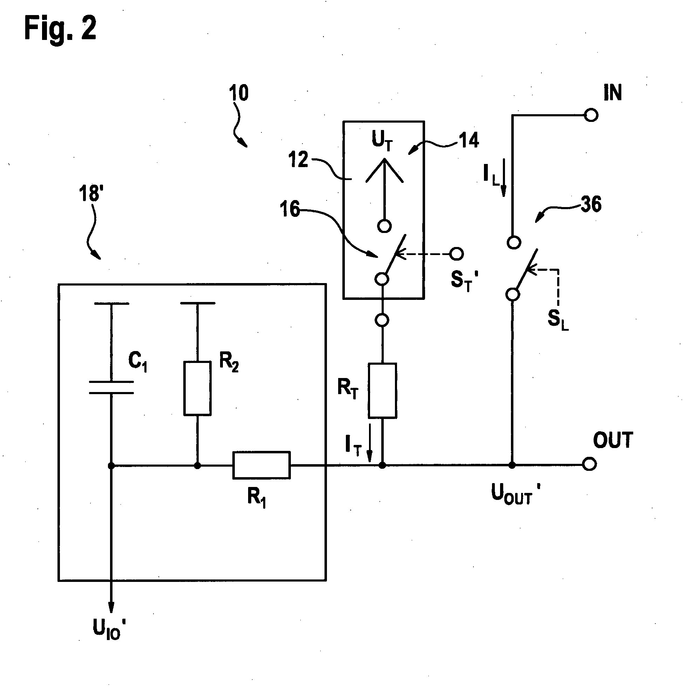

Fig. 2 zeigt einen Ausschnitt des Blockdiagramms der Schaltungsanordnung aus Fig. 1 mit einem ersten Beispiel der Signalaufbereitungseinheit 18'. Wie aus Fig. 2 ersichtlich ist, weist die Signalaufbereitungseinheit 18' zur Durchführung einer statischen Diagnose einen Spannungsteiler R₁, R₂, C₁ mit Tiefpassverhalten auf, welcher die Spannung U_{OUT}' am Ausgangsanschluss OUT aufbereitet und auf einen mit der Logik der Auswerte- und Steuereinheit 20 kompatiblen Pegel reduziert. In einem ersten statischen Diagnosefall erfasst die Signalaufbereitungseinheit 18' die resultierende Spannung U_{OUT}' am Ausgangsanschluss OUT bei geöffnetem Testschalter 16, welcher durch das Steuersignal S_{T}' entsprechend angesteuert wird, und gibt die korrespondierende durch den Spannungsteiler R₁, R₂, C₁ mit Tiefpassverhalten aufbereitete Testspannung U_{IO}' über die Schnittstelleneinheit 22 an die Auswerte- und Steuereinheit 20 zur Auswertung aus. In einem zweiten statischen Diagnosefall erfasst die Signalaufbereitungseinheit 18' die resultierende Spannung U_{OUT}' am Ausgangsanschluss OUT bei geschlossenem Testschalter 16, welcher durch das Steuersignal S_{T}' entsprechend angesteuert wird, wobei die resultierende Spannung U_{OUT}' durch einen Teststrom I_{T} bewirkt wird, welcher durch die in Fig. 2 nicht dargestellte Last 34 fließt. Die Signalaufbereitungseinheit 18' gibt die korrespondierende durch den Spannungsteiler R₁, R₂, C₁ mit Tiefpassverhalten aufbereitete Testspannung U_{IO}' zur Auswertung über die Schnittstelleneinheit 22 an die Auswerte- und Steuereinheit 20 aus. Die Auswerte- und Steuereinheit 20 wertet die korrespondierende aufbereitete Testspannung U_{IO}' in beiden stationären Diagnosefällen erst nach Ablauf einer vorgegebenen Zeitspanne im eingeschwungenen Zustand aus. Der Lastschalter 36 ist in beiden stationären Diagnosefällen geöffnet.

Die Auswerte- und Steuereinheit 20 erkennt einen Kurzschluss zwischen dem Pluspol (+) der Gleichspannungsquelle 32 und dem Ausgangsanschluss OUT der schaltbaren Last 34, wenn die korrespondierende aufbereitete Testspannung U_{IO}' im ersten statischen Diagnosefall und im zweiten statischen Diagnosefall einen hohen Pegel aufweist. Die Auswerte- und Steuereinheit 20 erkennt eine offene schaltbare Last 34 bzw. eine durchtrennte Anschlussleitung, wenn die korrespondierende aufbereitete Testspannung U_{IO}' im ersten statischen Diagnosefall und im zweiten statischen Diagnosefall unterschiedliche Pegel aufweisen. Bei einer offenen schaltbaren Last 34 bzw. bei einer durchtrennten Anschlussleitung stellt sich am Ausgangsanschluss OUT im ersten Diagnosefall eigentlich eine unbestimmte "floatende" Spannung ein. Da die Signalaufbereitungseinheit 18' typischer Weise eine Pull-up- oder Pull-down-Struktur aufweist kann die Schnittstelleneinheit 22 die floatende Spannung in einen hohen logischen Pegel im Falle einer Pull-up-Struktur oder in einen niedrigen logischen Pegel im Falle einer Pulldown-Struktur übersetzen. Um die offene schaltbare Last 34 bzw. die durchtrennte Anschlussleitung zu erkennen, versucht die Schaltungsanordnung 10 im zweiten statischen Diagnosefall den Teststrom I_{T} durch die schaltbare Last zu leiten. Wenn im zweiten statischen Diagnosefall der logische Zustand am Ausgangsanschluss OUT im Vergleich zum ersten statischen Diagnosefall vom niedrigen logischen Zustand auf den hohen logischen Zustand bzw. vom hohen logischen Zustand auf den niedrigen logischen Zustand geändert werden kann, schließt die Auswerte- und Steuereinheit 20 auf die offene schaltbare Last 34 bzw. die durchtrennte Anschlussleitung.

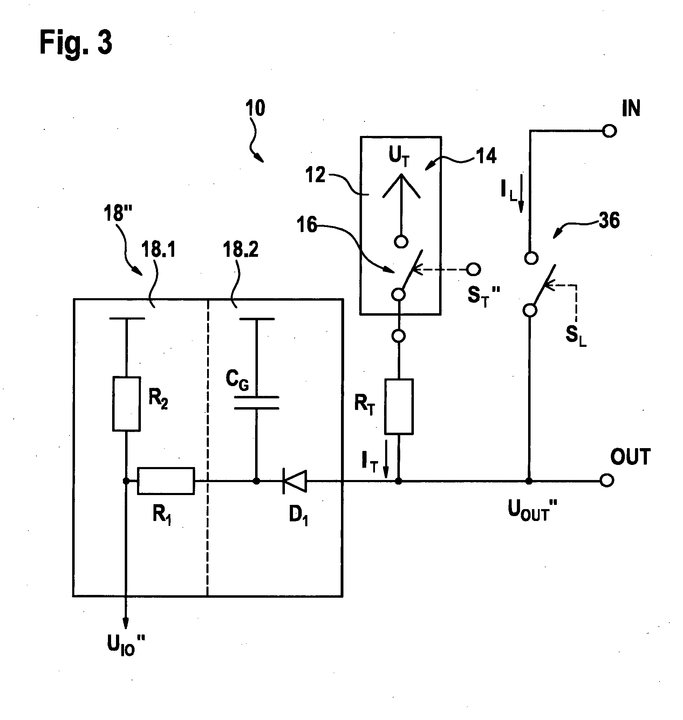

Die Auswerte- und Steuereinheit 20 erkennt einen Kurzschluss zwischen dem Minuspol (-) der Gleichspannungsquelle 32 und dem Ausgangsanschluss OUT der schaltbaren Last 34 oder eine nominale induktive schaltbare Last 34, wenn die korrespondierende aufbereitete Testspannung U_{IO}' im ersten statischen Diagnosefall und im zweiten statischen Diagnosefall einen niedrigen Pegel aufweist. Ohne die nachfolgend beschriebenen dynamischen Diagnosefälle kann die Auswerte- und Steuereinheit 20 im Fall einer induktiven Last 34 mit einem niedrigen ohmschen Widerstand R_{L} von weniger als 10Ω eine fehlerlose Last 34 nicht vom Kurzschluss zwischen dem Ausgangsanschluss OUT und dem Minuspol (-) der Gleichspannungsquelle 32 unterscheiden. Durch Ausnutzen der frequenzabhängigen Eigenschaften der schaltbaren induktiven Last 34 kann der fehlerlose Zustand der schaltbaren Last 34 erkannt werden. Wird beispielsweise eine sinusförmige oder rechteckförmige Wechselspannung an die schaltbare induktive Last 34 angelegt, dann kann die frequenzabhängige Impedanz der schaltbaren induktiven Last 34 gemessen bzw. ermittelt werden. Es ist jedoch wesentlich günstiger, einen einzelnen Rechteckimpuls an die schaltbare induktive Last 34 anzulegen und deren Sprungantwort über eine einfache Signalaufbereitungseinheit 18, 18" auszuwerten, wie nachfolgend unter Bezugnahme auf Fig. 3 bis 8 beschrieben wird.

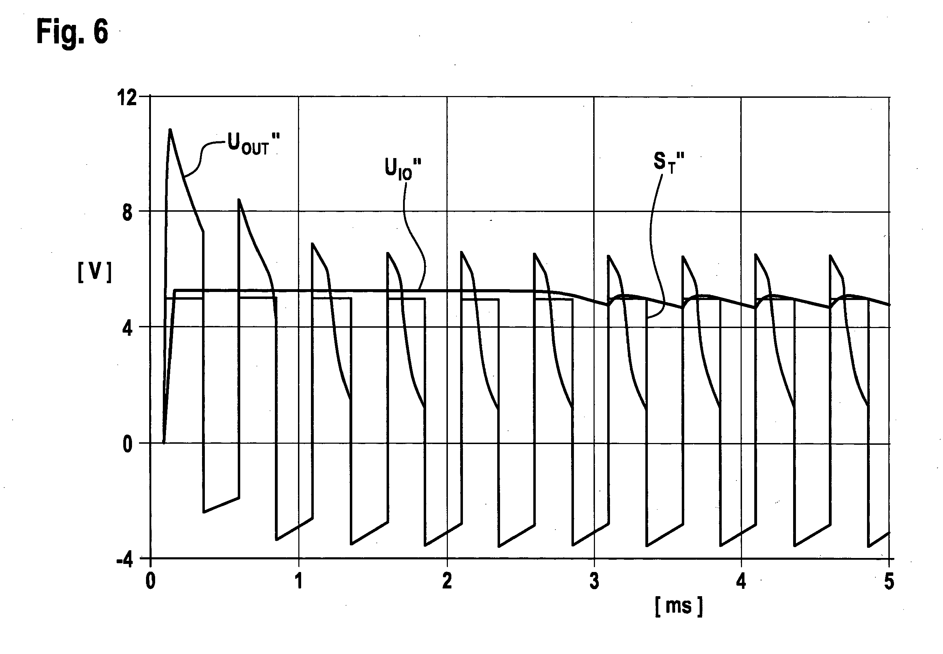

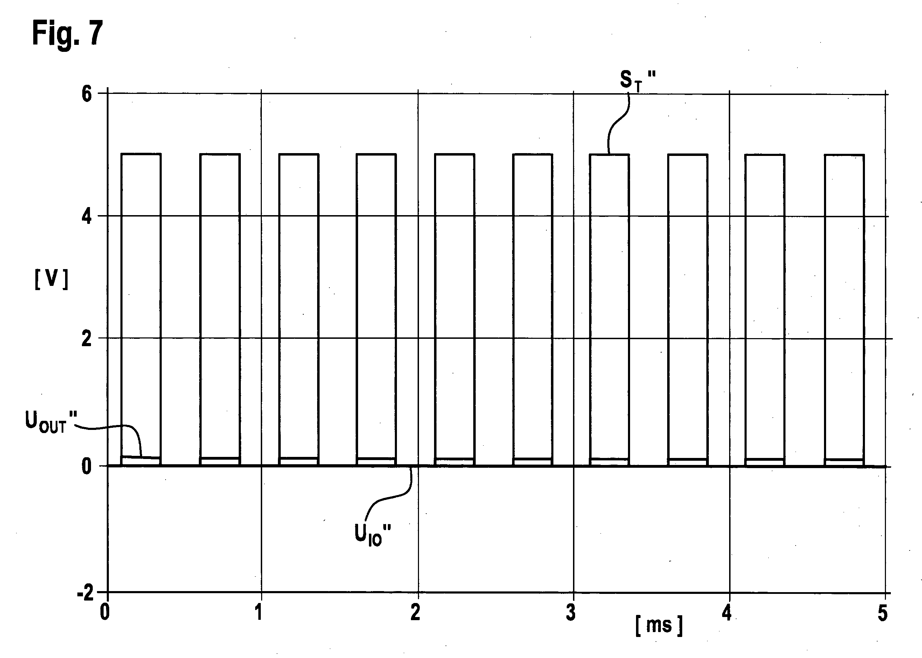

Fig. 3 zeigt einen Ausschnitt des Blockdiagramms der Schaltungsanordnung aus Fig. 1 mit einem zweiten Beispiel der Signalaufbereitungseinheit 18". Wie aus Fig. 3 ersichtlich ist, weist die Signalaufbereitungseinheit 18" im rechten Schaltungsteil 18.2 zur Durchführung einer dynamischen Diagnose einen Gleichrichter mit einer Diode D₁ und einem Glättungskondensator C_{G} auf. Im Signalweg ist nach dem Gleichrichter D₁, C_{G} im linken Schaltungsteil 18.1 ein Spannungsteiler mit einem ersten Widerstand R₁ und einem zweiten Widerstand R₂ angeordnet. In einem ersten dynamischen Diagnosefall wird der Testschalters 16 durch das Teststeuersignal S_{T}" mit einer vorgegebenen Frequenz zwischen einem geschlossenen und einem geöffneten Schaltzustand umgeschaltet, wobei die resultierende Spannung U_{OUT}' am Ausgangsanschluss OUT erfasst und die korrespondierende aufbereitete Testspannung U_{IO}" zur Ermittlung des Frequenzverhaltens der resultierenden Spannung U_{OUT}" am Ausgangsanschluss OUT ausgewertet werden. Fig. 6 und 7 zeigen jeweils die entsprechenden Signalverläufe während des ersten dynamischen Diagnosefalls, wobei Fig. 6 die Signalverläufe für eine fehlerfreie schaltbare induktive Last 34 zeigt, und wobei Fig. 7 die Signalverläufe für einen vorhandenen Kurzschluss zwischen dem Ausgangsanschluss OUT und dem Minuspol (-) der Gleichspannungsquelle zeigt. Durch den Gleichrichter D₁, C_{G} passieren nur positive Spannungspulse die Diode D1, während negative Spannungspulse geblockt werden.

Wie aus Fig. 6 ersichtlich ist, treten bei einer fehlerfreien induktiven Last 34 entsprechend der Schaltfrequenz des Teststeuersignals S_{T}" positive und negative Spannungsimpulse als resultierende Spannung U_{OUT}" am Ausgangsanschluss OUT auf. Durch den integrierenden Charakter der Gleichrichteranordnung D₁, C_{G} wird der Glättungskondensator C_{G} aufgeladen und es stellt sich ein im Wesentlichen konstanter hoher logischer Spannungspegel als Testspannung U_{IO}" ein. Reicht ein weitergeleiteter positiver Spannungsimpuls nicht aus, um den Glättungskondensator C_{G} aufzuladen, so kann eine vorgegebenen Anzahl von Spannungsimpulsen abgewartet werden, bis die aufbereitete Testspannung U_{IO}" am Ausgang der Signalaufbereitungseinheit 18" ausgewertet wird. Durch den Spannungsteiler R₁, R₂ wird der positive Pegel der Spannung U_{IO}" auf einen mit der Logik der Auswerte- und Steuereinheit 20 kompatiblen Pegel reduziert.

Wie aus Fig. 7 ersichtlich ist, treten bei einem Kurzschluss zwischen dem Ausgangsanschluss OUT und dem Minuspol (-) der Gleichspannungsquelle keine bzw. nur sehr kleine Spannungsimpulse als resultierende Spannung U_{OUT}" am Ausgangsanschluss OUT auf. Dadurch stellt sich ein niedriger logischer Spannungspegel als Testspannung U_{IO}" ein. Zusammenfassend erkennt die Auswerte- und Steuereinheit 20 im ersten dynamischen Diagnosefall eine nominale, d.h. fehlerfreie induktive schaltbare Last 34, wenn die korrespondierende aufbereitete Testspannung U_{IO}" einen hohen logischen Pegel aufweist. Die Auswerte- und Steuereinheit 20 erkennt im ersten Diagnosefall einen Kurzschluss zwischen dem Minuspol (-) der Gleichspannungsquelle 32 und dem Ausgangsanschluss OUT der schaltbaren Last 34, wenn die korrespondierende aufbereitete Testspannung U_{IO}" einen niedrigen logischen Pegel aufweist.

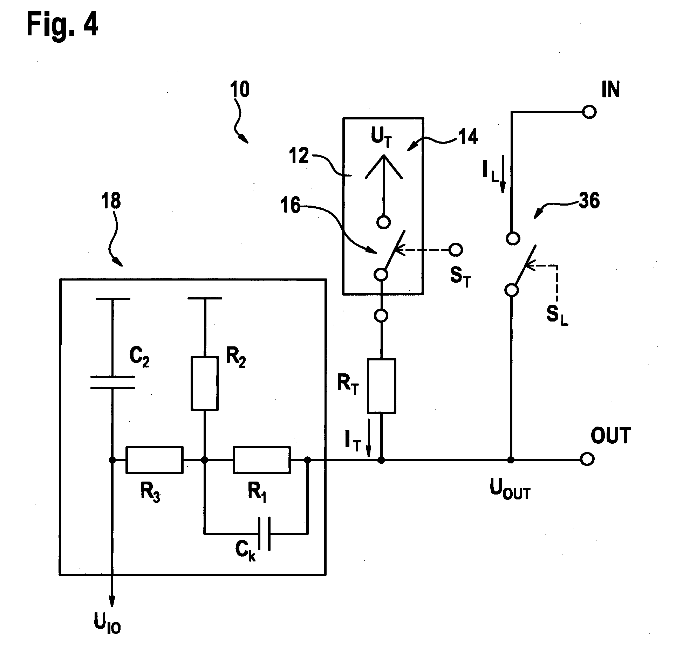

Fig. 4 zeigt einen Ausschnitt des Blockdiagramms der erfindungsgemäßen Schaltungsanordnung aus Fig. 1 mit einem Ausführungsbeispiel der Signalaufbereitungseinheit 18. Wie aus Fig. 4 ersichtlich ist, weist die Signalaufbereitungseinheit 18 zur Durchführung einer kombinierten statischen und dynamischen Diagnose einen Spannungsteiler R₁, R₂ auf, wobei parallel zu einem mit dem Ausgangsanschluss OUT verbundenen ersten Widerstand R₁ des Spannungsteilers R₁, R₂ ein Koppelkondensator C_{K} angeordnet ist. Im weiteren Signalweg ist nach dem Spannungsteiler R₁, R₂ ein Tiefpassfilter R₃, C₂ angeordnet Durch den Koppelkondensator C_{K} wird der erste Widerstand R₁ für Spannungsimpulse überbrückt, welche zum Tiefpassfilter R₃, C₂ weitergeleitet werden. Mit der Signalaufbereitungseinheit 18 für eine kombinierte statische und dynamische Diagnose führt die Auswerte- und Steuereinheit 20 zuerst die statische Diagnose und dann die dynamische Diagnose des Lastpfades 30 durch. Hierbei entspricht die statische Diagnose dem unter Bezugnahme auf Fig. 3 beschriebenen Ablauf, so dass hier auf eine erneute ausführliche Beschreibung der beiden statischen Diagnosefälle verzichtet wird.

Zusammenfassend erkennt die Auswerte- und Steuereinheit 20 durch die statischen Diagnose einen Kurzschluss zwischen dem Pluspol (+) der Gleichspannungsquelle 32 und dem Ausgangsanschluss OUT der schaltbaren Last 34, wenn die korrespondierende aufbereitete Testspannung U_{IO} im ersten statischen Diagnosefall und im zweiten statischen Diagnosefall einen hohen Pegel aufweist. Die Auswerte- und Steuereinheit 20 erkennt eine offene schaltbare Last 34 bzw. eine durchtrennte Anschlussleitung, wenn die korrespondierende aufbereitete Testspannung U_{IO} im ersten statischen Diagnosefall und im zweiten statischen Diagnosefall unterschiedliche Pegel aufweisen. Die Auswerte- und Steuereinheit 20 erkennt einen Kurzschluss zwischen dem Minuspol (-) der Gleichspannungsquelle 32 und dem Ausgangsanschluss OUT der schaltbaren Last 34 oder eine nominale induktive schaltbare Last 34, wenn die korrespondierende aufbereitete Testspannung U_{IO} im ersten statischen Diagnosefall und im zweiten statischen Diagnosefall einen niedrigen Pegel aufweist. Ohne die nachfolgend beschriebenen dynamischen Diagnosefälle kann die Auswerte- und Steuereinheit 20 im Fall einer induktiven Last 34 mit einem niedrigen ohmschen Widerstand R_{L} von weniger als 10Ω eine fehlerlose Last 34 nicht vom Kurzschluss zwischen dem Ausgangsanschluss OUT und dem Minuspol (-) der Gleichspannungsquelle 32 unterscheiden.

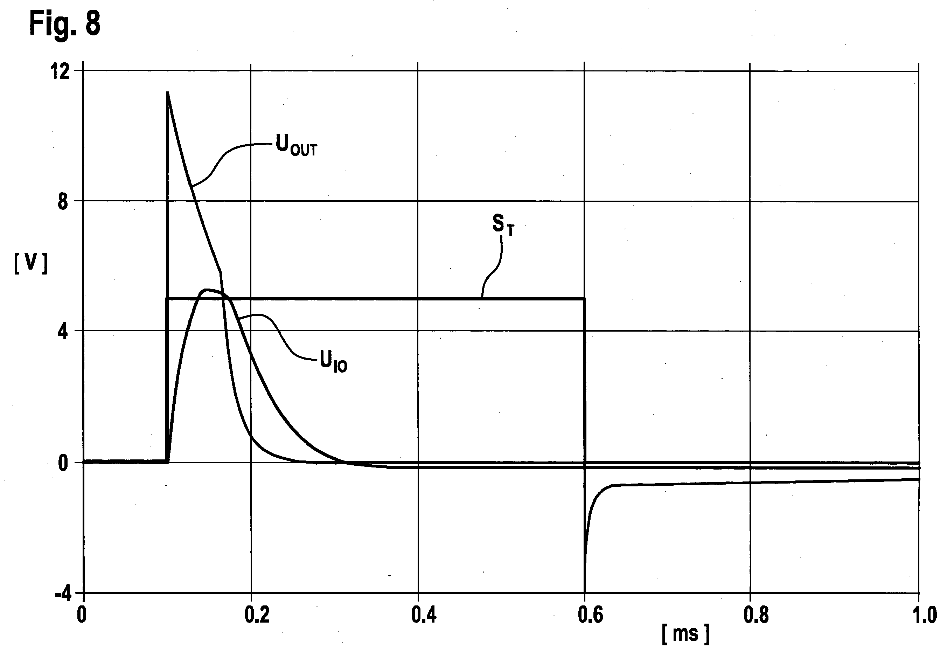

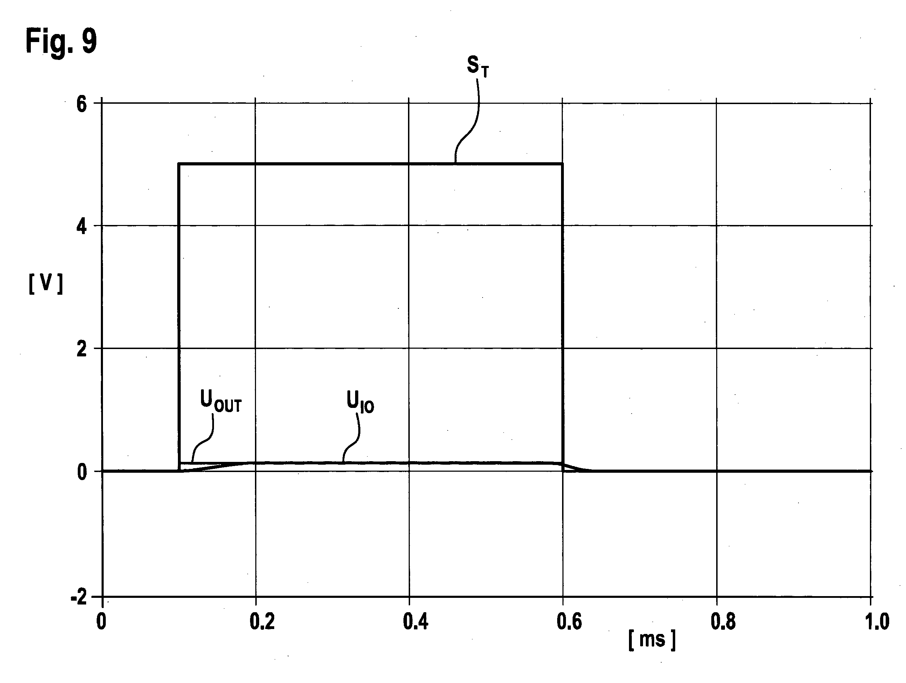

Nach der statischen Diagnose wird in einem zweiten dynamischen Diagnosefall der Schaltzustand des Testschalters 16 durch das Teststeuersignal S_{T} für eine vorgegebene Zeitspanne vom geöffneten Zustand in den geschlossen Zustand umgeschaltet. Die resultierende Spannung U_{OUT} wird am Ausgangsanschluss OUT erfasst und von der Signalaufbereitungseinheit 18 aufbereitet und als korrespondierende aufbereitete Testspannung U_{IO} zur Auswertung und Ermittlung des Frequenzverhaltens der schaltbaren Last 34 am Ausgangsanschluss OUT an die Auswerte- und Steuereinheit 20 ausgegeben. Fig. 8 und 9 zeigen jeweils die entsprechenden Signalverläufe während des zweiten dynamischen Diagnosefalls, wobei Fig. 8 die Signalverläufe für eine fehlerfreie schaltbare induktive Last 34 zeigt, und wobei Fig. 9 die Signalverläufe für einen vorhandenen Kurzschluss zwischen dem Ausgangsanschluss OUT und dem Minuspol (-) der Gleichspannungsquelle zeigt. Da der Widerstandswert des Testwiderstands R_{T} sehr viel größer als die Summe der Widerstandswerte des Lastwiderstands R_{L} und des Ersatzwiderstands R_{W} ist, wird die Zeitkonstante im Wesentlichen durch die Induktivität L und den Testwiderstand R_{T} bestimmt.

Wie aus Fig. 8 ersichtlich ist, treten bei einer fehlerfreien induktiven Last 34 an den Schaltübergängen des Teststeuersignals S_{T} ein entsprechender positiver Spannungsimpuls und ein entsprechender negativer Spannungsimpuls als resultierende Spannung U_{OUT} am Ausgangsanschluss OUT auf. Durch die Zeitkonstante ist der durch das Schließen des Testschalters 16 bewirkte Spannungsimpuls der resultierenden Spannung U_{OUT} am Ausgangsanschluss OUT wesentlich größer und breiter als der durch das Öffnen des Testschalters 16 bewirkte Spannungsimpuls. Die unterschiedlichen Spannungsimpulse führen auch ohne Gleichrichter zu einer positiven Spannungsdifferenz am Tiefpass R₃, C₂ und der dargestellten Sprungantwort als resultierende Spannung U_{OUT} am Ausgangsanschluss OUT bzw. als aufbereitete Testspannung U_{IO} am Ausgang der Signalaufbereitungseinheit 18. Die Auswerte- und Steuereinheit 20 führt die Auswertung der aufbereiteten Testspannung U_{IO} innerhalb der vorgegebenen Zeitspanne kurz nach dem Umschalten des Testschalters 16 durch, um den positiven Spannungsimpuls erfassen zu können. Somit erkennt die Auswerte- und Steuereinheit 20 im zweiten dynamischen Diagnosefall eine nominale induktive schaltbare Last 34, wenn die aufbereitete Testspannung U_{IO} nach dem Schließen des Testschalters 16 innerhalb der vorgegebenen Zeitspanne einen positiven Impuls aufweist. Die Auswerte- und Steuereinheit 20 erkennt im zweiten dynamischen Diagnosefall einen Kurzschluss zwischen dem Minuspol (-) der Gleichspannungsquelle 32 und dem Ausgangsanschluss OUT der schaltbaren Last 34, wenn die korrespondierende aufbereitete Testspannung U_{IO} während der vorgegebenen Zeitspanne unabhängig vom Schaltzustand des Testschalters 16 einen niedrigen Pegel aufweist.

Wie aus Fig. 9 ersichtlich ist, treten bei einem Kurzschluss zwischen dem Ausgangsanschluss OUT und dem Minuspol (-) der Gleichspannungsquelle keine bzw. nur sehr kleine Spannungsimpulse als resultierende Spannung U_{OUT} am Ausgangsanschluss OUT auf. Dadurch stellt sich ein niedriger logischer Spannungspegel als aufbereitete Testspannung U_{IO} ein. Zusammenfassend erkennt die Auswerte- und Steuereinheit 20 im zweiten dynamischen Diagnosefall eine nominale, d.h. fehlerfreie induktive schaltbare Last 34, wenn die korrespondierende aufbereitete Testspannung U_{IO} einen positiven Spannungsimpuls aufweist. Die Auswerte- und Steuereinheit 20 erkennt im zweiten Diagnosefall einen Kurzschluss zwischen dem Minuspol (-) der Gleichspannungsquelle 32 und dem Ausgangsanschluss OUT der schaltbaren Last 34, wenn die korrespondierende aufbereitete Testspannung U_{IO} einen niedrigen logischen Pegel aufweist.

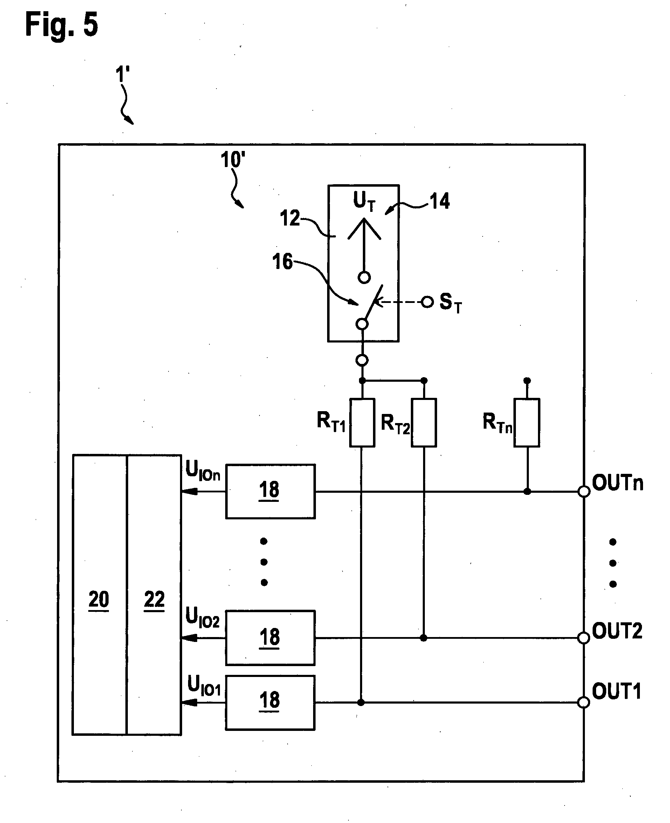

Fig. 5 zeigt ein schematisches Blockdiagramm eines Ausführungsbeispiels einer erfindungsgemäßen Schaltungsanordnung 1' zur Diagnose von mehreren Lastpfaden. Wie aus Fig. 5 ersichtlich ist, umfasst die Schaltungsanordnung 10' zur Diagnose von mehreren Lastpfaden, welche jeweils mit einem Ausgangsanschluss OUT1, OUT2, OUTn verbunden sind, eine Testspannungsquelle 12 und für jeden Ausgangsanschluss OUT1, OUT2, OUTn einen Testwiderstand R_{T1}, R_{T2}, R_{Tn} und eine Signalaufbereitungseinheit 18. Die Signalaufbereitungseinheiten 18 bereiten die jeweilige Spannung am korrespondierenden Ausgangsanschluss OUT1, OUT2, OUTn auf und geben jeweils eine korrespondierende aufbereitete Testspannung U_{IO1}, U_{IO2}, U_{IOn} zur Auswertung über eine Schnittstelleneinheit 22 an eine Auswerte- und Steuereinheit 20 aus. Die Diagnose der einzelnen Lastpfade erfolgt in Abhängigkeit von der Ausführung der Signalaufbereitungseinheit 18 gemäß den obigen Ausführungen.

Um Fehlfunktionen während der Diagnose des mindestens einen Lastpfads zu vermeiden, sind der mindestens eine Testwiderstand R_{T}, R_{T1}, R_{T2}, R_{T3} und die Widerstände R₁, R₂, R₃ in den verschiedenen Signalaufbereitungseinheiten 18, 18', 18" so aufeinander abgestimmt, dass der Teststrom I_{T} einen vorgegebenen Schwellwert nicht übersteigt, um eine Aktivierung der schaltbaren Last 34 zu verhindern.

Entsprechend dem erfindungsgemäßen Verfahren zur Diagnose eines Lastpfades in einem Fahrzeug, welcher eine Gleichspannungsquelle 32, eine mit einem Minuspol (-) dauerhaft verbundene schaltbare Last 34 und einen dauerhaft mit einem Pluspol (+) verbundenen Lastschalter 36 umfasst, welcher über ein Laststeuersignal S_{L} steuerbar ist, wobei im geschlossenen Zustand des Lastschalters 36 ein Laststrom I_{L} durch die schaltbare Last 34 leitbar ist, wird während der Diagnose ein Teststrom I_{T} mit einem definierten Pegel erzeugt und in Abhängigkeit von einem Teststeuersignal S_{T} über einen Testschalter 16 an einem Ausgangsanschluss OUT an die schaltbare Last 34 ausgegeben, wobei eine resultierende Spannung U_{OUT}, U_{OUT}', U_{OUT}" am Ausgangsanschluss OUT erfasst, aufbereitet und ausgewertet wird, wobei der Lastschalter 36 während der Diagnose geöffnet wird, und wobei über das Teststeuersignal S_{T} und den resultierenden Schaltzustand des Testschalters 16 mindestens zwei verschiedene Diagnosefälle erzeugt werden.

## Patentansprüche

1. Verfahren zur Diagnose eines Lastpfades in einem Fahrzeug, wobei der Lastpfad (30) eine Gleichspannungsquelle (32), eine mit einem Minuspol (-) dauerhaft verbundene schaltbare Last (34) und einen dauerhaft mit einem Pluspol (+) verbundenen Lastschalter (36) umfasst, welcher über ein Laststeuersignal (S_{L}) steuerbar ist, wobei im geschlossenen Zustand des Lastschalters (36) ein Laststrom (I_{L}) durch die schaltbare Last (34) leitbar ist, wobei während der Diagnose ein schaltbarer Teststrom (I_{T}) mit einem definierten Pegel erzeugt und in Abhängigkeit von einem Teststeuersignal (S_{T}) über einen Testschalter (16) an einem Ausgangsanschluss (OUT) an die schaltbare Last (34) ausgegeben wird, wobei eine resultierende Spannung (U_{OUT}, U_{OUT}', U_{OUT}") am Ausgangsanschluss (OUT) erfasst, aufbereitet und ausgewertet wird, wobei der Lastschalter (36) während der Diagnose geöffnet ist, wobei über das Teststeuersignal (S_{T}) und den resultierenden Schaltzustand des Testschalters (16) mindestens zwei verschiedene Diagnosefälle erzeugt werden, wobei die mindestens zwei verschiedenen Diagnosefälle statische und dynamische Diagnosefälle umfassen, wobei zur Erkennung und Unterscheidung von verschiedenen Lastpfadzuständen die statischen und dynamischen Diagnosefälle kombiniert werden, wobei in einem ersten statischen Diagnosefall die resultierende Spannung (U_{OUT}, U_{OUT}', U_{OUT}") am Ausgangsanschluss (OUT) bei geöffnetem Testschalter (16) erfasst und die korrespondierende aufbereitete Testspannung (U_{IO}, U_{IO}', U_{IO}", U_{IO1}, U_{IO2}, U_{IOn}) ausgewertet wird, wobei in einem zweiten statischen Diagnosefall die resultierende Spannung (U_{OUT}, U_{OUT}', U_{OUT}") am Ausgangsanschluss (OUT) bei geschlossenem Testschalter (16) erfasst und die korrespondierende aufbereitete Testspannung (U_{IO}, U_{IO}', U_{IO}", U_{IO1}, U_{IO2}, U_{IOn}) ausgewertet wird, wobei die aufbereitete Testspannung (U_{IO}, U_{IO}', U_{IO}", U_{IO1}, U_{IO2}, U_{IOn}) jeweils erst nach Ablauf einer vorgegebenen Zeitspanne im eingeschwungenen Zustand ausgewertet wird, **dadurch gekennzeichnet, dass** eine nominale induktive schaltbare Last (34) erkennbar ist, wenn die korrespondierende aufbereitete Testspannung (U_{IO}, U_{IO}', U_{IO}", U_{IO1}, U_{IO2}, U_{IOn}) im ersten statischen Diagnosefall und im zweiten statischen Diagnosefall einen niedrigen Pegel aufweist.

2. Verfahren nach Anspruch 1, **dadurch gekennzeichnet, dass** in einem ersten dynamischen Diagnosefall der Testschalter (16) durch das Teststeuersignal (S_{T}) mit einer vorgegebenen Frequenz zwischen einem geschlossenen und einem geöffneten Schaltzustand umgeschaltet wird, wobei die resultierende Spannung (U_{OUT}, U_{OUT}', U_{OUT}") am Ausgangsanschluss (OUT) erfasst und die korrespondierende aufbereitete Testspannung (U_{IO}, U_{IO}', U_{IO}", U_{IO1}, U_{IO2}, U_{IOn}) zur Ermittlung des Frequenzverhaltens der schaltbaren Last (34) am Ausgangsanschluss (OUT) ausgewertet wird.

3. Verfahren nach Anspruch 1, **dadurch gekennzeichnet, dass** in einem zweiten dynamischen Diagnosefall der Testschalter (16) innerhalb einer vorgegebenen Zeitspanne mindestens einmal geschlossen und wieder geöffnet wird, wobei die resultierende Spannung (U_{OUT}, U_{OUT}', U_{OUT}") am Ausgangsanschluss (OUT) erfasst und die korrespondierende aufbereitete Testspannung (U_{IO}, U_{IO}', U_{IO}", U_{IO1}, U_{IO2}, U_{IOn}) innerhalb der vorgegebenen Zeitspanne zur Ermittlung des Sprungantwortverhaltens der schaltbaren Last (34) am Ausgangsanschluss (OUT) ausgewertet wird.

4. Verfahren nach einem der Ansprüche 1 bis 3, **dadurch gekennzeichnet, dass** ein Kurzschluss zwischen dem Pluspol (+) der Gleichspannungsquelle (32) und dem Ausgangsanschluss (OUT) der schaltbaren Last (34) erkannt wird, wenn die korrespondierende aufbereitete Testspannung (U_{IO}, U_{IO}', U_{IO}", U_{IO1}, U_{IO2}, U_{IOn}) im ersten statischen Diagnosefall und im zweiten statischen Diagnosefall einen hohen Pegel aufweist und/oder eine offene schaltbare Last (34) erkannt wird, wenn die korrespondierende aufbereitete Testspannung (U_{IO}, U_{IO}', U_{IO}", U_{IO1}, U_{IO2}, U_{IOn}) im ersten statischen Diagnosefall und im zweiten statischen Diagnosefall unterschiedliche Pegel aufweist.

5. Verfahren nach einem der Ansprüche 1 bis 4, **dadurch gekennzeichnet, dass** ein Kurzschluss zwischen dem Minuspol (-) der Gleichspannungsquelle (32) und dem Ausgangsanschluss (OUT) der schaltbaren Last (34) erkennbar ist, wenn die korrespondierende aufbereitete Testspannung (U_{IO}, U_{IO}', U_{IO}", U_{IO1}, U_{IO2}, U_{IOn}) im ersten statischen Diagnosefall und im zweiten statischen Diagnosefall einen niedrigen Pegel aufweist.

6. Verfahren nach Anspruch 5, **dadurch gekennzeichnet, dass** eine nominale induktive schaltbare Last (34) erkannt wird, wenn die korrespondierende aufbereitete Testspannung (U_{IO}, U_{IO}', U_{IO}", U_{IO1}, U_{IO2}, U_{IOn}) im ersten dynamischen Diagnosefall einen hohen Pegel aufweist oder wenn die korrespondierende aufbereitete Testspannung (U_{IO}, U_{IO}', U_{IO}", U_{IO1}, U_{IO2}, U_{IOn}) im zweiten dynamischen Diagnosefall nach dem Schließen des Testschalters (16) innerhalb der vorgegebenen Zeitspanne einen positiven Impuls aufweist, wobei ein Kurzschluss zwischen dem Minuspol (-) der Gleichspannungsquelle (32) und dem Ausgangsanschluss (OUT) der schaltbaren Last (34) erkannt wird, wenn die korrespondierende aufbereitete Testspannung (U_{IO}, U_{IO}', U_{IO}", U_{IO1}, U_{IO2}, U_{IOn}) im ersten dynamischen Diagnosefall einen niedrigen Pegel aufweist oder wenn die korrespondierende aufbereitete Testspannung (U_{IO}, U_{IO}', U_{IO}", U_{IO1}, U_{IO2}, U_{IOn}) im zweiten dynamischen Diagnosefall während der vorgegebenen Zeitspanne unabhängig vom Schaltzustand des Testschalters (16) einen niedrigen Pegel aufweist.

7. Schaltungsanordnung zur Diagnose eines Lastpfades in einem Fahrzeug, insbesondere zur Durchführung des Verfahrens nach einem der Ansprüche 1 bis 6, wobei der Lastpfad (30) eine Gleichspannungsquelle (32), eine mit einem Minuspol (-) dauerhaft verbundene schaltbare Last (34) und einen dauerhaft mit einem Pluspol (+) verbundenen Lastschalter (36) umfasst, welcher über ein Laststeuersignal (S_{L}) steuerbar ist, wobei im geschlossenen Zustand des Lastschalters (36) ein Laststrom (I_{L}) durch die schaltbare Last (34) leitbar ist, wobei mindestens eine Testspannungsquelle (12), welche eine Spannungsquelle (14) und einen von einem Teststeuersignal (S_{T}) gesteuerten Testschalter (16) umfasst und so ausgeführt ist, dass während der Diagnose über mindestens einen Testwiderstand (R_{T}, R_{T1}, R_{T2}, R_{T3}) ein Teststrom (I_{T}) mit einem definierten Pegel erzeugbar und an einem Ausgangsanschluss (OUT) an die schaltbare Last (34) ausgebbar ist, und eine Signalaufbereitungseinheit (18, 18', 18") vorgesehen sind, welche dazu eingerichtet ist, während der Diagnose eine resultierende Spannung (U_{OUT}, U_{OUT}', U_{OUT}") am Ausgangsanschluss (OUT) zu erfassen und eine aufbereitete Testspannung (U_{IO}, U_{IO}', U_{IO}", U_{IO1}, U_{IO2}, U_{IOn}) zur Auswertung an eine Auswerte- und Steuereinheit (20) auszugeben, wobei der Lastschalter (36) während der Diagnose geöffnet ist, und wobei über das Teststeuersignal (S_{T}) und den resultierenden Schaltzustand des Testschalters (16) mindestens zwei verschiedene Diagnosefälle erzeugbar sind, **dadurch gekennzeichnet, dass** die Signalaufbereitungseinheit (18) zur Durchführung einer kombinierten statischen und dynamischen Diagnose einen Spannungsteiler (R₁, R₂) aufweist, wobei parallel zu einem mit dem Ausgangsanschluss (OUT) verbundenen ersten Widerstand (R₁) des Spannungsteilers (R₁, R₂) ein Koppelkondensator (C_{K}) angeordnet ist, und wobei im Signalweg nach dem Spannungsteiler (R₁, R₂) ein Tiefpassfilter (R₃, C₂) angeordnet ist.

8. Schaltungsanordnung nach Anspruch 7, **dadurch gekennzeichnet, dass** die Auswerte- und Steuereinheit (20) zuerst die statische Diagnose und dann die dynamische Diagnose des Lastpfades (30) durchführt.

9. Schaltungsanordnung nach Anspruch 7 oder 8, **dadurch gekennzeichnet, dass** der mindestens eine Testwiderstand (R_{T}, R_{T1}, R_{T2}, R_{T3}) und die Widerstände (R₁, R₂, R₃) in der Signalaufbereitungseinheit (18, 18', 18") so aufeinander abgestimmt sind, dass der Teststrom (I_{T}) einen vorgegebenen Schwellwert nicht übersteigt, um eine Aktivierung der schaltbaren Last (34) zu verhindern.

## Claims

1. Method for diagnosis on a load path in a vehicle, wherein the load path (30) comprises a DC voltage source (32), a switchable load (34) that is permanently connected to a negative pole (-) and a load switch (36) that is permanently connected to a positive pole (+) and that can be controlled by means of a load control signal (S_{L}), wherein when the load switch (36) is in the closed state it is possible for a load current (I_{L}) to be carried by the switchable load (34), wherein during the diagnosis a switchable test current (I_{T}) having a defined level is produced and is output to the switchable load (34) via a test switch (16) at an output connection (OUT) on the basis of a test control signal (S_{T}), wherein a resultant voltage (U_{OUT}, U_{OUT}', U_{OUT}") at the output connection (OUT) is sensed, conditioned and evaluated, wherein the load switch (36) is open during the diagnosis, wherein the test control signal (S_{T}) and the resultant switching state of the test switch (16) are used to produce at least two different diagnosis cases, wherein the at least two different diagnosis cases comprise static and dynamic diagnosis cases, wherein, in order to recognize and distinguish between different load path states, the static and dynamic diagnosis cases are combined, wherein in a first static diagnosis case the resultant voltage (U_{OUT}, U_{OUT}', U_{OUT}") at the output connection (OUT) is sensed when the test switch (16) is open, and the corresponding conditioned test voltage (U_{IO}, U_{IO}', U_{IO}", U_{IO1}, U_{IO2}, U_{IOn},) is evaluated, wherein in a second static diagnosis case the resultant voltage (U_{OUT}, U_{OUT}', U_{OUT}") at he output connection (OUT) is sensed when the test switch (16) is closed, and the corresponding conditioned test voltage (U_{IO}, U_{IO}', U_{IO}", U_{IO1}, U_{IO2}, U_{IOn}) is evaluated, wherein the conditioned test voltage (U_{IO}, U_{IO}', U_{IO}", U_{IO1}, U_{IO2}, U_{IOn}) is only ever evaluated after a prescribed period of time in the steady state has elapsed, **characterized in that** a nominal inductive switchable load (34) can be recognized when the corresponding conditioned test voltage (U_{IO}, U_{IO}', U_{IO}", U_{IO1}, U_{IO2}, U_{IOn}) has a low level in the first static diagnosis case and in the second static diagnosis case.

2. Method according to Claim 1, **characterized in that** in a first dynamic diagnosis case the test switch (16) is changed over between a closed and an open switching state by the test control signal (S_{T}) at a prescribed frequency, wherein the resultant voltage (U_{OUT}, U_{OUT}', U_{OUT}") at the output connection (OUT) is sensed and the corresponding conditioned test voltage (U_{IO}, U_{IO}', U_{IO}", U_{IO1}, U_{IO2}, U_{IOn}) is evaluated for the purpose of ascertaining the frequency response of the switchable load (34) at the output connection (OUT).

3. Method according to Claim 1, **characterized in that** in a second dynamic diagnosis case the test switch (16) is closed and opened again at least once within a prescribed period of time, wherein the resultant voltage (U_{OUT}, U_{OUT}', U_{OUT}") at the output connection (OUT) is sensed and the corresponding conditioned test voltage (U_{IO}, U_{IO}', U_{IO}", U_{IO1}, U_{IO2}, U_{IOn}) is evaluated within the prescribed period of time for the purpose of ascertaining the step response behavior of the switchable load (34) at the output connection (OUT).

4. Method according to one of Claims 1 to 3, **characterized in that** a short circuit between the positive pole (+) of the DC voltage source (32) and the output connection (OUT) of the switchable load (34) is recognized when the corresponding conditioned test voltage (U_{IO}, U_{IO}', U_{IO}", U_{IO1}, U_{IO2}, U_{IOn}) has a high level in the first static diagnosis case and in the second static diagnosis case and/or an open switchable load (34) is recognized when the corresponding conditioned test voltage (U_{IO}, U_{IO}', U_{IO}", U_{IO1}, U_{IO2}, U_{IOn}) has different levels in the first static diagnosis case and in the second static diagnosis case.

5. Method according to one of Claims 1 to 4, **characterized in that** a short circuit between the negative pole (-) of the DC voltage source (32) and the output connection (OUT) of the switchable load (34) can be recognized when the corresponding conditioned test voltage (U_{IO}, U_{IO}', U_{IO}", U_{IO1}, U_{IO2}, U_{IOn}) has a low level in the first static diagnosis case and in the second static diagnosis case.

6. Method according to Claim 5, **characterized in that** a nominal inductive switchable load (34) is recognized when the corresponding conditioned test voltage (U_{IO}, U_{IO}', U_{IO}", U_{IO1}, U_{IO2}, U_{IOn}) has a high level in the first dynamic diagnosis case or when the corresponding conditioned test voltage (U_{IO}, U_{IO}', U_{IO}", U_{IO1}, U_{IO2}, U_{IOn}) has a positive pulse in the second dynamic diagnosis case following the closure of the test switch (16) within the prescribed period of time, wherein a short circuit between the negative pole (-) of the DC voltage source (32) and the output connection (OUT) of the switchable load (34) is recognized when the corresponding conditioned test voltage (U_{IO}, U_{IO}', U_{IO}", U_{IO1}, U_{IO2}, U_{IOn}) has a low level in the first dynamic diagnosis case or when the corresponding conditioned test voltage (U_{IO}, U_{IO}', U_{IO}", U_{IO1}, U_{IO2}, U_{IOn}) has a low level in the second dynamic diagnosis case during the prescribed period of time irrespective of the switching state of the test switch (16).

7. Circuit arrangement for diagnosis on a load path in a vehicle, particularly for carrying out the method according to one of Claims 1 to 6, wherein the load path (30) comprises a DC voltage source (32), a switchable load (34) that is permanently connected to a negative pole (-) and a load switch (36) that is permanently connected to a positive pole (+) and that can be controlled by means of a load control signal (S_{L}), wherein in the closed state of the load switch (36) it is possible for a load current (I_{L}) to be carried by the switchable load (34), wherein there are provided at least one test voltage source (12), which comprises a voltage source (14) and a test switch (16) controlled by a test control signal (S_{T}) and is embodied such that during the diagnosis it is possible for at least one test resistance (R_{T}, R_{T1}, R_{T2}, R_{T3}) to be used to produce a test current (I_{T}) having a defined level and to output said test current to the switchable load (34) at an output connection (OUT), and a signal conditioning unit (18, 18', 18") which is set up to sense, during the diagnosis, a resultant voltage (U_{OUT}, U_{OUT}', U_{OUT}") at the output connection (OUT) and to output a conditioned test voltage (U_{IO}, U_{IO}', U_{IO}", U_{IO1}, U_{IO2}, U_{IOn}) to an evaluation and control unit (20) for the purpose of evaluation, wherein the load switch (36) is open during the diagnosis, and wherein the test control signal (S_{T}) and the resultant switching state of the test switch (16) can be used to produce at least two different diagnosis cases, **characterized in that** the signal conditioning unit (18) has a voltage divider (R₁, R₂) for the purpose of performing a combined static and dynamic diagnosis, wherein a coupling capacitor (C_{K}) is arranged in parallel with a first resistor (R₁) of the voltage divider (R₁, R₂), which resistor is connected to the output connection (OUT), and wherein the signal path downstream of the voltage divider (R₁, R₂) contains a low-pass filter (R₃, C₂).

8. Circuit arrangement according to Claim 7, **characterized in that** the evaluation and control unit (20) performs first the static diagnosis and then the dynamic diagnosis on the load path (30).

9. Circuit arrangement according to Claim 7 or 8, **characterized in that** the at least one test resistance (R_{T}, R_{T1}, R_{T2}, R_{T3}) and the resistance (R₁, R₂, R₃) in the signal conditioning unit (18, 18', 18") are attuned to one another such that the test current (I_{T}) does not exceed a prescribed threshold value in order to prevent the switchable load (34) from being activated.

## Revendications

1. Procédé de diagnostic d'un trajet de charge dans un véhicule, le trajet de charge (30) comprenant une source de tension continue (32), une charge commutable (34) reliée en permanence à un pôle négatif (-) et un commutateur de charge (36) relié en permanence à un pôle positif (+), lequel peut être commandé par le biais d'un signal de commande de charge (S_{L}), un courant de charge (I_{L}) pouvant passer à travers la charge commutable (34) lorsque le commutateur de charge (36) est dans l'état fermé, un courant de test commutable (I_{T}) ayant un niveau défini étant généré pendant le diagnostic et délivré en fonction d'un signal de commande de test (S_{T}) par le biais d'un commutateur de test (16) sur une borne de sortie (OUT) à la charge commutable (34), une tension résultante (U_{OUT}, U_{OUT}', U_{OUT}") étant collectée, conditionnée et interprétée sur la borne de sortie (OUT), le commutateur de charge (36) étant ouvert pendant le diagnostic, au moins deux cas de diagnostic différents étant générés par le biais du signal de commande de test (S_{T}) et de l'état de commutation résultant du commutateur de test (16), les au moins deux cas de diagnostic différents comprenant des cas de diagnostic statiques et dynamiques, les cas de diagnostic statiques et dynamiques étant combinés en vue de reconnaître et de différencier différents états de trajet de charge, la tension résultante (U_{OUT}, U_{OUT}', U_{OUT}") dans un premier cas de diagnostic statique étant collectée sur la borne de sortie (OUT) lorsque le commutateur de test (16) est ouvert et la tension de test (U_{IO}, U_{IO}', U_{IO}", U_{IO1}, U_{IO2}, U_{IOn}) conditionnée correspondante étant interprétée, la tension résultante (U_{OUT}, U_{OUT}', U_{OUT}") dans un deuxième cas de diagnostic statique étant collectée sur la borne de sortie (OUT) lorsque le commutateur de test (16) est fermé et la tension de test (U_{IO}, U_{IO}', U_{IO}", U_{IO1}, U_{IO2}, U_{IOn}) conditionnée correspondante étant interprétée, la tension de test (U_{IO}, U_{IO}', U_{IO}", U_{IO1}, U_{IO2}, U_{IOn}) conditionnée étant à chaque fois interprétée seulement après écoulement d'un intervalle de temps prédéfini dans l'état de régime transitoire, **caractérisé en ce qu'**une charge commutable (34) inductive nominale peut être reconnue lorsque la tension de test (U_{IO}, U_{IO}', U_{IO}", U_{IO1}, U_{IO2}, U_{IOn}) conditionnée correspondante dans le premier cas de diagnostic statique et dans le deuxième cas de diagnostic statique présente un faible niveau.

2. Procédé selon la revendication 1, **caractérisé en ce que** dans un premier cas de diagnostic dynamique, le commutateur de test (16) est basculé par le signal de commande de test (S_{T}) à une fréquence prédéfinie entre un état de commutation fermé et un état de commutation ouvert, la tension résultante (U_{OUT}, U_{OUT}', U_{OUT}") sur la borne de sortie (OUT) étant collectée et la tension de test (U_{IO}, U_{IO}', U_{IO}", U_{IO1}, U_{IO2}, U_{IOn}) conditionnée correspondante étant interprétée pour déterminer le comportement en fréquence de la charge commutable (34) sur la borne de sortie (OUT).

3. Procédé selon la revendication 1, **caractérisé en ce que** dans un deuxième cas de diagnostic dynamique, le commutateur de test (16) est au moins une fois fermé puis de nouveau ouvert pendant un intervalle de temps prédéfini, la tension résultante (U_{OUT}, U_{OUT}', U_{OUT}") sur la borne de sortie (OUT) étant collectée et la tension de test (U_{IO}, U_{IO}', U_{IO}", U_{IO1}, U_{IO2}, U_{IOn}) conditionnée correspondante étant interprétée à l'intérieur de l'intervalle de temps prédéfini pour déterminer le comportement en réponse transitoire de la charge commutable (34) sur la borne de sortie (OUT).

4. Procédé selon l'une des revendications 1 à 3, **caractérisé en ce qu'**un court-circuit entre le pôle positif (+) de la source de tension continue (32) et la borne de sortie (OUT) de la charge commutable (34) est reconnu lorsque la tension de test (U_{IO}, U_{IO}', U_{IO}", U_{IO1}, U_{IO2}, U_{IOn}) conditionnée correspondante, dans le premier cas de diagnostic statique et dans le deuxième cas de diagnostic statique, présente un niveau élevé et/ou une charge commutable (34) ouverte est reconnue lorsque la tension de test (U_{IO}, U_{IO}', U_{IO}", U_{IO1}, U_{IO2}, U_{IOn}) conditionnée correspondante, dans le premier cas de diagnostic statique et dans le deuxième cas de diagnostic statique, présente des niveaux différents.

5. Procédé selon l'une des revendications 1 à 4, **caractérisé en ce qu'**un court-circuit entre le pôle négatif (-) de la source de tension continue (32) et la borne de sortie (OUT) de la charge commutable (34) peut être reconnu lorsque la tension de test (U_{IO}, U_{IO}', U_{IO}", U_{IO1}, U_{IO2}, U_{IOn}) conditionnée correspondante, dans le premier cas de diagnostic statique et dans le deuxième cas de diagnostic statique, présente un faible niveau.

6. Procédé selon la revendication 5, **caractérisé en ce qu'**une charge commutable (34) inductive nominale est reconnue lorsque la tension de test (U_{IO}, U_{IO}', U_{IO}", U_{IO1}, U_{IO2}, U_{IOn}) conditionnée correspondante dans le premier cas de diagnostic dynamique présente un niveau élevé ou lorsque la tension de test (U_{IO}, D_{IO}', U_{IO}", U_{IO1}, U_{IO2}, U_{IOn}) conditionnée correspondante dans le deuxième cas de diagnostic dynamique, après la fermeture du commutateur de test (16) à l'intérieur de l'intervalle de temps prédéfini, présente une impulsion positive, un court-circuit entre le pôle négatif (-) de la source de tension continue (32) et la borne de sortie (OUT) de la charge commutable (34) pouvant être reconnu lorsque la tension de test (U_{IO}, U_{IO}, U_{IO}", U_{IO1}, U_{IO2}, U_{IOn}) conditionnée correspondante, dans le premier cas de diagnostic dynamique, présente un faible niveau ou lorsque la tension de test (U_{IO}, U_{IO}', U_{IO}", U_{IO1}, U_{IO2}, U_{IOn}) conditionnée correspondante, dans le deuxième cas de diagnostic dynamique, présente un faible niveau pendant l'intervalle de temps prédéfini indépendamment de l'état de commutation du commutateur de test (16).

7. Arrangement de circuit pour le diagnostic d'un trajet de charge dans un véhicule, notamment pour mettre en oeuvre le procédé selon l'une des revendications 1 à 6, le trajet de charge (30) comprenant une source de tension continue (32), une charge commutable (34) reliée en permanence à un pôle négatif (-) et un commutateur de charge (36) relié en permanence à un pôle positif (+), lequel peut être commandé par le biais d'un signal de commande de charge (S_{L}), un courant de charge (I_{L}) pouvant passer à travers la charge commutable (34) lorsque le commutateur de charge (36) est dans l'état fermé, au moins une source de tension de test (12), laquelle comprend une source de tension (14) et un commutateur de test (16) commandé par un signal de commande de test (S_{T}) et est réalisée de telle sorte qu'un courant de test (I_{T}) ayant un niveau défini peut être généré pendant le diagnostic par le biais d'au moins une résistance de test (R_{T}, R_{T1}. R_{T2}, R_{T3}) et délivré sur une borne de sortie (OUT) à la charge commutable (34), ainsi qu'une unité de conditionnement de signal (18, 18', 18") étant prévues, laquelle est conçue pour, pendant le diagnostic, collecter une tension résultante (U_{OUT}, U_{OUT}', U_{OUT}") sur la borne de sortie (OUT) et délivrer une tension de test (U_{IO}, U_{IO}', U_{IO}", U_{IO1}, U_{IO2}, U_{IOn}) conditionnée en vue de son interprétation à une unité d'interprétation et de commande (20), le commutateur de charge (36) étant ouvert pendant le diagnostic, et au moins deux cas de diagnostic différents pouvant être générés par le biais du signal de commande de test (S_{T}) et de l'état de commutation résultant du commutateur de test (16), **caractérisé en ce que** l'unité de conditionnement de signal (18) présente, pour réaliser un diagnostic statique et dynamique combiné, un diviseur de tension (R₁, R₂), un condensateur de couplage (C_{K}) étant disposé en parallèle avec une première résistance (R₁) du diviseur de tension (R₁, R₂) reliée à la borne de sortie (OUT) et un filtre passe-bas (R₃, C₂) étant disposé dans le chemin du signal après le diviseur de tension (R₁, R₂).

8. Arrangement de circuit selon la revendication 7, **caractérisé en ce que** l'unité d'interprétation et de commande (20) effectue tout d'abord le diagnostic statique et ensuite le diagnostic dynamique du trajet de charge (30).

9. Arrangement de circuit selon la revendication 7 ou 8, **caractérisé en ce que** l'au moins une résistance de test (R_{T}, R_{T1}, R_{T2}, R_{T3}) et les résistances (R₁, R₂, R₃) dans l'unité de conditionnement de signal (18, 18', 18") sont accordées les unes aux autres de telle sorte que le courant de test (I_{T}) ne dépasse pas une valeur de seuil prédéfinie afin d'éviter une activation de la charge commutable (34).
